Europäisches Patentamt

European Patent Office

Office européen des brevets

(19)

(11) Publication number: **0 193 673**
**A2**

# (12) EUROPEAN PATENT APPLICATION

(21) Application number: 85306643.9

(51) Int. Cl.⁴: **G 03 F 1/00, G 03 B 41/00**

(22) Date of filing: **18.09.85**

(30) Priority: **01.03.85 US 707437**

(43) Date of publication of application: **10.09.86**
**Bulletin 86/37**

(84) Designated Contracting States: **AT BE DE FR GB NL SE**

(71) Applicant: **GOULD INC., 10 Gould Center, Rolling Meadows, IL 60008 (US)**

(72) Inventor: **Young, Peter, 7 Blanchard Circle, South Barrington, IL. 60010 (US)**
Inventor: **Oprysko, Modest M., 613 Plum Grove Road 1B, Roselle, IL. 60172 (US)**
Inventor: **Beranek, Mark W., 724 Gettysburg Drive, Arlington Heights, IL. 60004 (US)**

(74) Representative: **Barrett, James William et al, A.A. THORNTON & CO. Northumberland House 303-306 High Holborn, London WC1V 7LE (GB)**

(54) Apparatus for photomask repair.

(57) An apparatus for repairing both clear and opaque defects in a photomask having a metal film pattern on a glass plate in which a visible laser light source is pulsed at selected frequencies to direct an optically focused laser beam into a gas sealed cell containing a mask. At one frequency, the laser pulses ablate opaque mask defects. At another frequency, and with the cell filled with a metal bearing gas, the laser beam causes thermal decomposition of the gas and deposition of metal to cure clear defects.

This invention relates generally to the repair of photomasks used to manufacture integrated circuits and more particularly concerns apparatus using laser energy for such repairs.

A photomask used in integrated circuit production is a flat optical glass plate having an opaque pattern defined by a thin film of deposited metal, commonly chrome. A clear defect in such a mask is an area of glass that should have an opaque metal film but does not, and hence is clear. An opaque defect in a mask is an area of film on the glass where it should not be. Repairing mask defects has become more difficult as the scale to which masks are made has become smaller. Modern masks are made to definitions of 1 to 2 microns.

Apparatus is commercially available for repairing opaque mask defects by focusing laser light energy on the defect to vaporize and scatter the film molecules. Such apparatus using microscope optics has become quite automated, including computer control of the optical X-Y table and the laser source so that a mask can be scanned, the position of opaque defects noted and stored as compared to a proper mask pattern, and then placed in the apparatus for computer controlled positioning of the mask and operation of the laser to ablate the defects. By tightly focusing the laser through the optics of such an apparatus, high definition in correction is achieved.

To the present time, such apparatus cannot, with the same precision and control, correct clear defects in photomasks. However, a method has been developed offering precision and control in the use of a laser for curing clear defects -- see European patent application No. 85303092.2 which is hereby incorporated by reference.

It is an object of the present invention to embody in a single apparatus the ability to correct both clear and opaque photomask defects using a highly focused, high definition laser beam. A collateral object is to provide an apparatus of this kind which makes possible the creation of an automated apparatus for curing photomask defects.

Another object of the invention is to provide for an apparatus of the above type a cell for controlling the location and surrounding environment of a photomask under repair. A related object is to provide a cell as characterized above which permits visible light access to the photomask, for both viewing and laser repair, and allows the close positioning of the mask and the focusing optics required for high definition work. A further object is to provide a cell of the foregoing kind which is easy to use and inexpensive to manufacture and maintain.

Other objects and advantages of the invention will become apparent upon reading the following detailed description and upon reference to the drawings, in which:

Figure 1 is a schematic of an apparatus embodying the present invention;

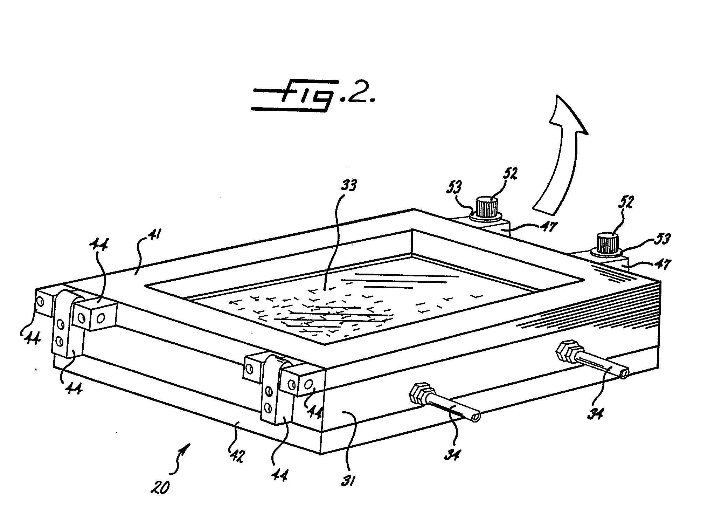

Fig. 2 is a perspective of a cell used in the apparatus of Fig. 1;

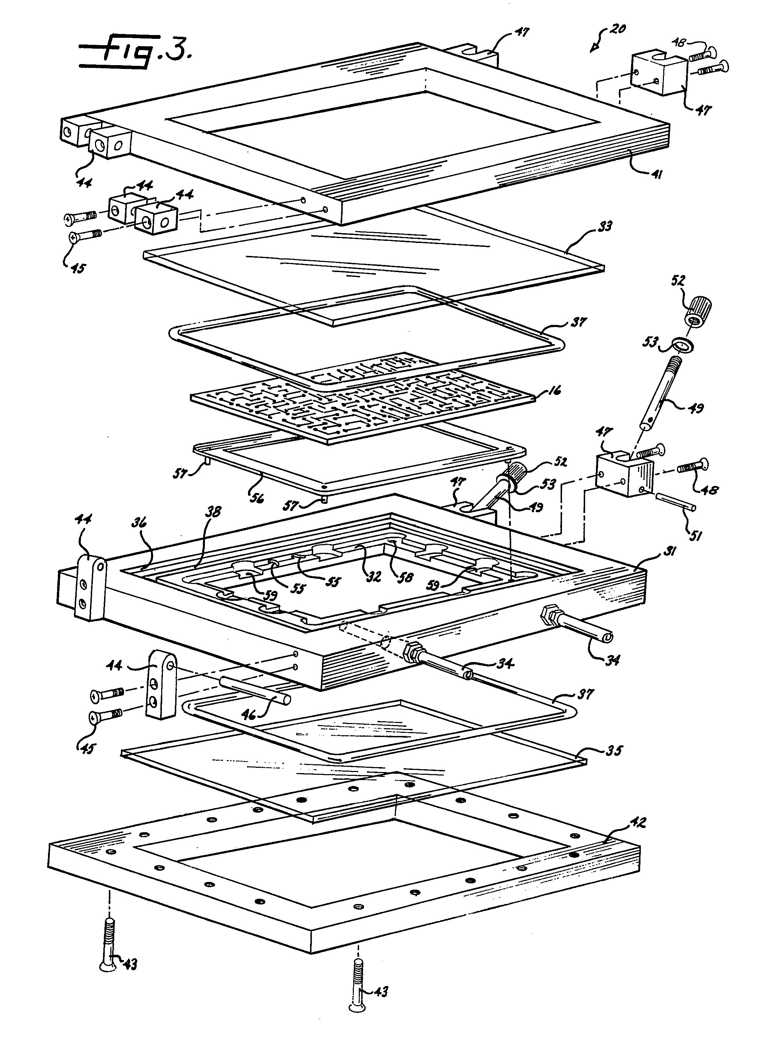

Fig. 3 is an exploded perspective of the cell shown in Fig. 2; and

Fig. 4 is a chart showing expected phenomenon resulting from different modes of laser operation.

While the invention will be described in connection with a preferred embodiment, it will be understood that we do not intend to limit the invention to that embodiment. On the contrary, we intend to cover all alternatives, modifications and equivalents as may be included within the scope of the invention as defined by the appended claims.

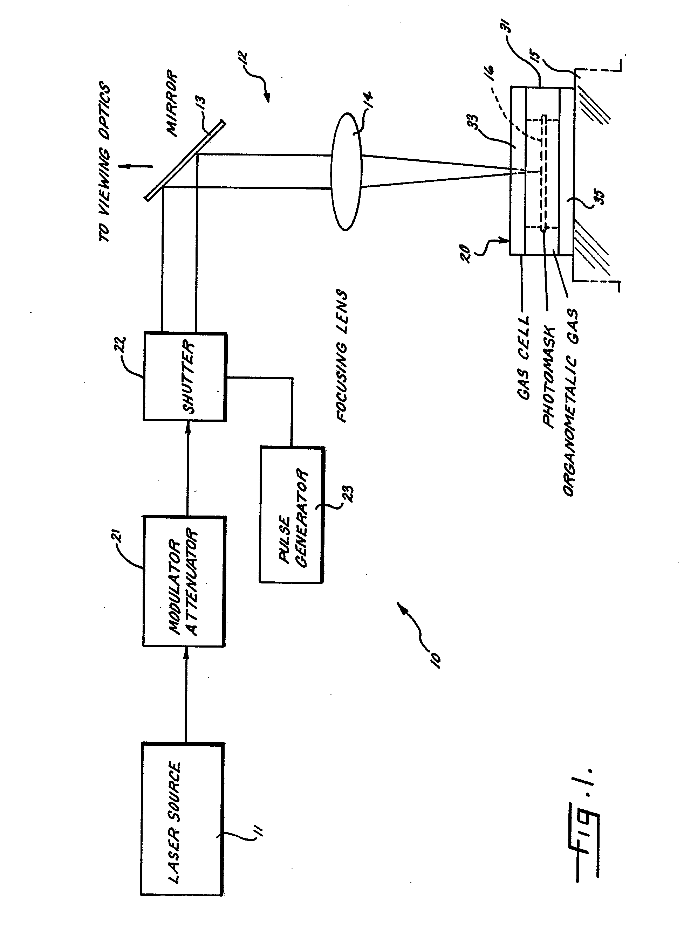

Turning to the drawings, there is schematically shown in Fig. 1 an apparatus 10 embodying the invention and including a laser source 11 positioned to deliver laser light pulses to what is essentially a microscope 12 of which is shown a mirror 13, optics in the form of a focusing objective lens 14, and an x-y table 15 underlying the optics. A photomask 16 being worked upon is supported within a closed cell 20 that is securely mounted on the table 15 and hence can be positioned relative to the focusing point of the optics by the usual movement of the table 15. As suggested by Fig. 1, microscope viewing optics are above the mirror permitting the photomask 16 to be inspected and visually positioned.

As disclosed in the aforementioned application the laser source 11 should be selected to generate visible laser light having a wave length of from 0.4 to 2.0 microns. This permits the use of standard microscope optics. A laser delivering more than 10 kilowatts per square centimeter of power has been found suitable.

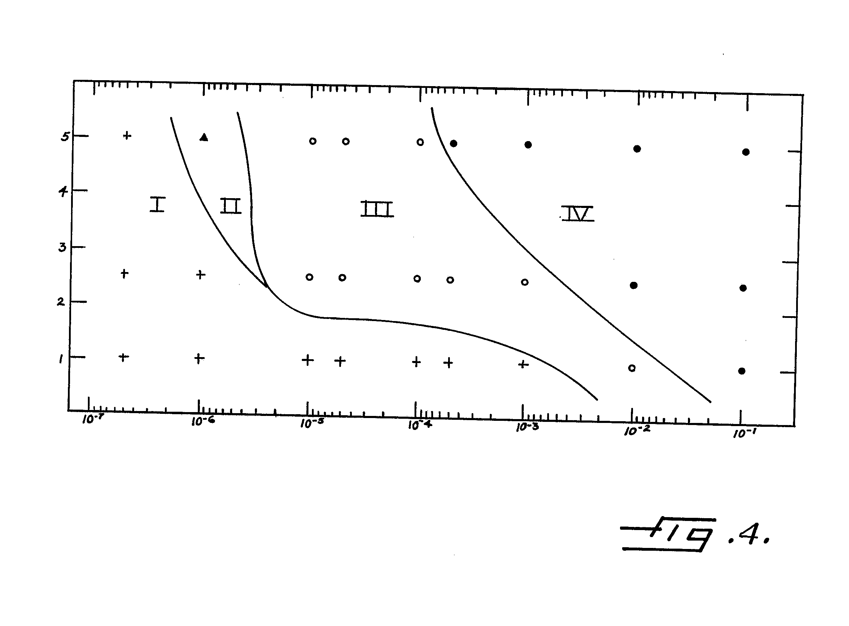

In carrying out the invention, laser light is delivered to the photomask as a focused timed pulse at a selected frequency. The frequency can vary, depending on the effect desired, from a single pulse to a train of pulses at well over 100 Hz. Delivered laser power is controlled by a modulator/attenuator 21, and pulse duration and frequency is controlled by a shutter 22 driven by a pulse generator 23. Typically, pulses from one microsecond up to one second are used. The chart of Fig. 4 shows the effect of 400 nsec pulses at laser powers in the range of 1 to 5 watts, the scale on the vertical axis. Pulse frequencies are more than 100 hz and vary from 0.1 of a second between pulses, at the right of the horizontal axis scale of the Fig. 4 chart, to less than a millionth of a second between pulses, the value at the left of the horizontal chart scale. By varying the frequency of the short pulses, through the control of the pulse generator 23, different effects on the photomask are achieved. This is displayed by the Fig. 4 chart in the form of regions 1 through 4. A discussion of these effects will follow.

Pursuant to the invention, the cell 20 includes a flat frame 31 having a recess 32 for receiving the photomask 16, a glass cover 33 for closing and sealing a mask in the frame with the mask and the cover being closely spaced and a pair of lines 34 for gas-charging the cell and surrounding the mask with a metal bearing gas. The close spacing of the cover 33 and the upper surface of the photomask 16 permits the required short distance between the optics of the microscope 12 and the metal film pattern on the mask so that the laser light can be focused with precision. A working distance of under 10 millimeters is desirable.

The lines 34 permit the practice of the method disclosed in the aforementioned application wherein the cell is charged with an organometallic gas and the sharply focused laser light causes thermal deposition of metal from the gas on precisely located areas of the mask, thus correcting so-called clear defects. In more detail, the laser beam is first focused of the edge of existing chrome film on the mask just adjacent the clear defect to be rendered opaque. The laser energy scatters molecules of chrome over the adjacent area to form a still transparent nucleation layer. The laser is then focused on the defect area, which might be only one or two microns in length or width, and the area is heated by the laser energy to the point that the gas in contact with that area is thermally decomposed and a film of metal from the gas is deposited. The film is opaque and thus constitutes the correction for the clear defect.

In the preferred embodiment, the bottom of the frame 31 is sealed by a second glass cover 35, the covers 33, 35 are positioned in shallow frame recesses 36, only one of which is shown, and the covers and frame 31 are sealed by O-rings fitted in frame grooves 38, only one of which is shown. The covers 33, 35 are pressed against the top and bottom of the frame 31 by open centered plates 41 and 42, respectively, which are secured to the frame. The recesses 36 have a depth equalling the thickness of the covers 33, 35 so that the covers can be pressed against the frame, and this compresses the O-rings 37 into the grooves 38 a predetermined amount to produce a uniform and reliable gas seal.

The plate 42 is secured to the frame by a plurality of screws 43. The plate 41 is latched against the frame so that it can be lifted to release the cover 33 and provide access to the photomask 16. In the illustrated embodiment, one side of the plate 41 is hinged to the frame by hinge members 44 secured by screws 45 and connected by pins 46. On the other side, notched latch blocks 47 are secured to the plate 41 and the frame 31 by screws 48. Rods 49 are pivoted by pins 51 in one set of latch blocks 47, and the rods threadably carry heads 52 positioned above washers 53. It can be readily seen that the plate 41 can be swung to and from the frame 31 and that, when the plate is on the frame, the rods 49 can be lifted to extend through the notches of overlying blocks 47, and then the heads 52 can be tightened against the washers 53 to securely and firmly hold the plate 41 against the frame 31.

Preferably, the covers 33, 35 are formed of optical quality glass of the kind used to make photomasks. With both the top and bottom of the cell 20 being transparent, the mask in the cell can be viewed either by reflected or transmitted light. The lower plate 42 may be locked to the x-y table 15 of the microscope in any suitable manner. To establish a fixed relationship between a photomask and the cell 20, and thus between the photomask and the x-y table 15 since the cell is locked to the table, springs 55 are mounted in the recess 32 so as to bias the photomask 16 into a fixed position relative to the frame 31.

Photomasks may vary in thickness, typically being from 0.06 to 0.15 of an inch thick. To keep the film pattern side of a mask close to the cover 33 regardless of the mask thickness, one or more spacers 56 of varying thickness are provided to fit in the recess 32 beneath a photomask. The spacers are held in position by corner pins 57 that fit in locating holes 58 in the frame recess 32. Spacers 56 of appropriate thickness are selected to match the thickness of the photomask being repaired so as to keep the top of the mask close to the cover 33.

To insure that gas introduced into the cell flows to both sides of the mask, a plurality of notches 59 are formed in the frame 31 so as to extend through the recess 32. The notches 59 thus form passages around the edges of a photomask resting in the recess 32 and gas can easily flow to both sides of the mask and completely fill, or to completely evacuate, the cell. It will be apparent that the pair of lines 34 readily permits the cell 20 to be either charged or purged with appropriate gas valved to the lines.

The repair of clear mask defects through the thermal decomposition and deposition of metal has been referred to above. Opaque defects can be corrected in the usual fashion by directing the focused laser beam onto the undesired chrome film and vaporizing the defect. Present equipment typically uses a single high power laser pulse of short duration for this purpose, such as a 10 nanosecond pulse having a 100 watt peak power. This is substantially different, and requires a substantially different laser setting achievable with the apparatus 10, from what is typically required for depositing metal as discussed above. In that case, a lower power, long duration pulse is called for, such as a 10 milliwatt pulse 20 milliseconds long when the cell contains a vapor pressure of 12 Torr of $Al(CH_3)_3$ gas.

It has also been found that both clear and opaque defects can be corrected with the photomask supported in the metal bearing gas environment of the cell 20 by varying the frequency of the laser pulses. Returning to the chart of Fig. 4, if the pulse power and frequency is in the region numbered 4, the effect of the pulses at the point of focus is to ablate the existing chrome film -- which would be

0193673

the correction of opaque defects. If the pulse power
and frequency is in the region numbered 1, the
rapidity of the pulses generates sufficient heat at
the point of focus that thermal decompositon takes
place and metal from the gas is deposited -- which is
the correction of clear defects. Regions 2 and 3
produce intermediate or combined effects. In region
3, the ablation of the existing metal occurred
followed, if the pulsing continued, by the deposition
of metal. In region 2, the effect was to deposit
metal but, at the very center of the focused beam, to
vaporize or ablate the metal so as to produce a small
hole at the center of focus.

Yet another process can be performed efficiently
by the apparatus 10 to correct photomasks, and that
is the correction of clear defects by photoresist
darkening. A process utilizing laser radiation for
that purpose is disclosed in United States patent
application Serial No. 622,367, filed June 20, 1984,
hereby incorporated by reference. Basically, the
process involves coating the area to be corrected
with an appropriate polymer and utilizing a focused
laser beam to char and darken the desired area of the
coating so that the charred area will resist
subsequent washing in a solvent effective to remove
the remaining coating. It will be apparent that the
apparatus 10 with its provision for precisely
locating a focused laser beam of controlled energy is
well suited to perform that method. In this case,
the no enclosed cell is required and the cell 20 can
be either used as an open fixture or some other
fixture can hold the photomask.

The obvious advantage of the apparatus 10 is to
permit the correction of both clear and opaque
defects in a photomask using a single apparatus.

Beyond this, those skilled in the art will understand that the apparatus 10 corresponds in large part to existing apparatus for dealing with opaque defects that is highly automated and computer controlled. The principles involved in automatically scanning and storing photomask defects for removing opaque defects can be easily extended to noting clear defects as well and, using the controls and structure described above, correcting those defects. It is therefore possible to scan a photomask once for both clear and opaque defects, and to process that mask once with the laser power and/or pulse frequency being appropriately controlled to correct all defects in that one pass.

The sealed cell 20 is obviously critical to the practice of the invention, and it will be apparent that the cell 20 is of straightforward economical design that is easy to handle and maintain.

We claim as our invention:

1. An apparatus for repairing photomasks comprising, in combination, a cell for positioning and enclosing a photomask, visible light optics positioned to focus on a mask in said cell, a movable table supporting said cell for positioning the cell and the enclosed mask relative to said optics, a laser light source positioned to direct a laser beam through said optics and into said cell, and means for causing said source to emit laser light pulses of selected power and duration and at selectable frequency including a single pulse.

2. The combination of claim 1 in which said source emits laser light having a wavelength of 0.4 to 2.0 microns, and said means permitting pulses less than one second and frequencies greater than 1 Hz.

3. The combination of claim 1 including means for gas charging said cell and thus surrounding said photomask with a metal bearing gas.

4. The combination of claim 1 in which said cell includes a flat frame having a recess for receiving a photomask, and a glass cover for closing and sealing a mask in said frame with the mask and cover being closely spaced.

5. A cell for controlling the position and environment of a photomask comprising a flat frame having a recess for receiving and supporting a glass photomask, a glass cover sealed to said frame over and closely spaced from said recess, means for sealing the bottom of said frame so that a photomask in said recess is completely enclosed in a sealed region while remaining visible through said glass cover, and means for delivering or removing selected gases from said sealed region.

6. The combination of claim 5 in which said means for sealing is a second glass cover, said covers being pressed against the top and bottom of said frame by open centered plates, said frame having O-ring grooves and O rings in the grooves to provide gas tight seals between said covers and the frame.

7. The combination of claim 6 in which the upper one of said plates is latched against said frame so that it can be lifted to release the glass cover and provide access to a photomask in said recess.

8. The combination of claim 5 in which said frame has notches extending through said recess so that gas on one side of the photomask set in said recess can easily flow to the other side of the mask.

9. An apparatus for heating a micron size area of a photomask coated with a polymer comprising, in combination, a fixture for positioning the photomask, visible light optics positioned to focus on the photomask in said fixture, a movable table supporting said fixture for positioning said photomask in fixture relative to said optics, a laser source positioned to direct a laser beam through said optics onto said photomask, and means for causing said source to emit laser light pulses of selected power and duration at selectable frequency including a single pulse.

Fig. 1.

Fig.2.

Fig.3.

0193673

fig.4.